# EUROPEAN PATENT SPECIFICATION

(11) **EP 4 427 209 B1**
(45) Date of publication and mention of the grant of the patent: **23.09.2026**
(21) Application number: 22802757.9
(22) Date of filing: 01.11.2022
(51) Int. Cl.: G08B 21/18

(54) **A SENSOR DEVICE, A SYSTEM, A METHOD AND A COMPUTER PROGRAM FOR DETECTION OF ELECTRICAL ABNORMALITIES IN ASSOCIATION WITH ELECTRICAL EQUIPMENT**
SENSORVORRICHTUNG, SYSTEM, VERFAHREN UND COMPUTERPROGRAMM ZUR ERKENNUNG VON ELEKTRISCHEN ANOMALIEN IN ZUSAMMENHANG MIT EINER ELEKTRISCHEN AUSRÜSTUNG
DISPOSITIF DE DÉTECTION, SYSTÈME, PROCÉDÉ ET PROGRAMME INFORMATIQUE POUR LA DÉTECTION D'ANOMALIES ÉLECTRIQUES EN ASSOCIATION AVEC UN ÉQUIPEMENT ÉLECTRIQUE

(30) Priority: 02.11.2021 SE 2151345
(43) Date of publication of application: 11.09.2024
(73) Proprietor: Eliguard AB, 545 21 Töreboda (SE)
(72) Inventor: MAGNUSSON, Fredrik, 132 37 Saltsjö-boo (SE); FRYKHOLM, Gustav, 118 30 Stockholm (SE)
(74) Representative: Zacco Sweden AB
(86) International application number: PCT/SE2022/051001
(87) International publication number: WO 2023/080824

(56) References cited:
- WO-A1-2015/101426
- WO-A1-2019/145976
- US-A1- 2018 074 112

## Description

### TECHNICAL FIELD

The present disclosure relates to a method, computer program and system for detection of electrical abnormalities in association with electrical equipment. More specifically, the disclosure relates to a method, a computer program and a system for detection of electrical abnormalities in association with electrical equipment as defined in the introductory parts of claim 1, claim 8 and claim 9.

### BACKGROUND ART

Electrical abnormalities, such as sparks, electric arcs and increased heat may occur in association with electrical equipment, for example due to various failures or overvoltage. Such abnormalities may lead to a fire and consequently to severe damage of the electrical equipment and its surroundings. In order to detect abnormalities and thereby prevent damages, various types of alert systems and devices exist, including voltage monitors, optical sensors and/or acoustic sensors. Most of these systems and devices are, however, very complex and expensive. Furthermore, many of these systems react to abnormalities too late, when the damage has already occurred or the fire already started.

As an example, US 2020/0144806 A1 discloses a method and device for detecting the formation of an electric arc in an electrical system from its acoustic signature. The system comprises an acoustic sensor, such as an ultrasound sensor, configured to detect acoustic waves in the electrical system. The sensor can be arranged on a wall of a housing of the electrical system, or in physical contact with the electrical conductor that one wishes to monitor.

US 10366596 BB discloses a monitoring system for detecting electrical equipment failure. The system includes an ultrasonic sensor mounted for example on the inside of a door or wall of a cabinet facing the electrical equipment. The ultrasonic sensor can be used to set a threshold sound level representative of ultrasonic emissions radiating from the electrical equipment in good working order. During monitoring, the ultrasonic sensor can detect when an event of arcing, tracking, or corona occurs because the sound level will be above the ambient threshold.

US2018/074112A1 describes a system for detecting sparks using acoustic wave sensor and implementing a frequency domain analysis. When the energy within a spectral band exceeds a threshold an arc is determined. WO2015/101426A1 discloses that acoustic sensor signals are analysed in frequency bands with respect to the energy and compared to reference spectra to determine abnormal states or potential arcs. WO2019/145976A1 describes an acoustic sensor used to detect sparks through using a band pass filter to separate the spark signature from noise. When frequency content exceeds threshold, a spark is identified. This document was merely cited as general background art and is no more relevant for the amended claims.

While the above-mentioned systems according to prior art addresses some of the problems associated with systems for detecting electrical abnormalities, they often fail to provide an accurate and reliable monitoring and often detect the potential danger too late. There is thus a need for an improved method and system for detection of electrical abnormalities in association with electrical equipment.

### SUMMARY

It is an object of the present disclosure to mitigate, alleviate or eliminate one or more of the deficiencies and disadvantages in the prior art and solve at least one of the current problems. It is a particular object of the present disclosure to provide a method and system for detection of electrical abnormalities in association with electrical equipment, which is cost-efficient, reliable and robust.

Yet another object of the present disclosure is to provide a method and means for detection of electrical abnormalities, which by accurate and reliable monitoring enable timely alerts and thereby reduce the risk of severe damages.

According to one aspect of the present disclosure there is provided a method for detection of electrical abnormalities in association with electrical equipment. The method comprises the steps of registering, by means of an acoustic sensor device during a calibration process, acoustic signals reflecting sound of the electrical equipment during normal operation thereof, and determining an energy content threshold value for acoustic signals within at least one frequency band to be monitored during monitoring of the electrical equipment following the calibration process, based on the acoustic signals registered within the at least one frequency band during the calibration process. The method further comprises the steps of detecting, among the acoustic signals registered by the acoustic sensor device during monitoring of the electrical equipment following the calibration process, an acoustic pulse within the at least one frequency band, and classifying the acoustic pulse as an electrical abnormality associated with the electrical equipment when an energy content of the acoustic pulse exceeds the energy content threshold value for the at least one frequency band.

This provides a cost-efficient, reliable and robust way of monitoring electrical equipment in order to detect electrical abnormalities, including but not limited to formation of sparks, electrical arcs, corona discharge, tracking and sudden increase in temperature of the electric equipment. By listening to the background level of acoustic noise generated by the electrical equipment during normal operation thereof, and determining the energy content threshold value based on the acoustic signals registered within a specific frequency band to be monitored, the threshold value can be set relatively low, thereby increasing the sensitivity in electrical abnormality detection.

In some embodiments, the frequency band is preset based on the type of electrical equipment to be monitored and/or based on the electrical surroundings of the electrical equipment to be monitored. In this way, the frequency band can be preset in dependence of a known frequency spectrum of acoustic noise normally generated by the type of electrical equipment to be monitored and/or by electrical appliances in the surroundings of the electrical equipment to be monitored.

In some embodiments, the frequency band is determined based on the acoustic signals registered by the acoustic sensor device during the calibration process, generated by the electrical equipment during normal operation thereof, which acoustic signals represent background noise generated by the electrical equipment during normal operation thereof.

In some embodiments, the method may comprise the steps of comparing energy contents of different frequencies of the acoustic signals registered during the calibration process, and determining the frequency band to be monitored as a frequency band having a relatively low energy content, based on the comparison.

The frequency band should preferably be narrow enough to exclude high-energy content acoustic signals generated by the electrical equipment during normal operation thereof. Preferably, the frequency band should have a bandwidth of at most 100 Hz, preferably at most 75 Hz, and even more preferably at most 50 Hz.

Depending on the background noise generated by the electrical equipment to be monitored and electrical appliances in the surroundings of the electrical equipment to be monitored, a suitable centre frequency of the frequency band may be 1 kHz or 4,5 kHz.

It has been found that acoustic pulses generated by the above-mentioned types of electrical abnormalities has a very short duration in time. Therefore, to make the method more robust by preventing other sounds from being mistaken for an electrical abnormality, the method may comprise the steps of determining a pulse duration time of the acoustic pulse and classifying the acoustic pulse as an electrical abnormality only if the pulse duration time is below a maximum pulse duration threshold value. When defined as a period of time during which the energy content of the acoustic pulse exceeds the energy content threshold value, the maximum pulse duration threshold value may, e.g., be set to a value in the range of 15-50 ms. Preferably, the maximum pulse duration threshold value should be at most 40 ms, even more preferably at most 30 ms, and most preferably at most 20 ms.

It has further been found that acoustic pulses generated by the above-mentioned types of electrical abnormalities have a very sudden increase and decrease in energy content. Therefore, to make the method even more robust, classification of the pulse as an electrical abnormality may be performed based on a rate of increase and/or a rate of decrease of the energy content of the acoustic pulse.

In some embodiments, the method may comprise the steps of determining a measure indicative of a rate of increase of energy content of the acoustic pulse, and classifying the acoustic pulse as an electrical abnormality only when the measure of the rate of increase exceeds a set threshold value. This may be achieved, e.g., by determining an acoustic energy ramp-up time of the acoustic pulse, and classifying the acoustic pulse as an electrical abnormality only if the acoustic energy ramp-up time is below a maximum acoustic energy ramp-up threshold value. When defined as a period of time from a first point in time at which the energy content of the acoustic pulse exceeds the energy content threshold value to a second point in time at which the energy content of the acoustic pulse reaches its maximum value, the maximum acoustic energy ramp-up threshold value may, for example, be set to a value in the range of 10-40 ms. Preferably, the maximum acoustic energy ramp-up threshold value should be at most 30 ms, even more preferably at most 20 ms, and most preferably at most 10 ms.

Likewise, in some embodiments, the method may comprise the steps of determining a measure indicative of a rate of decrease of energy content of the acoustic pulse, and classifying the acoustic pulse as an electrical abnormality only when the measure of the rate of decrease exceeds a set threshold value. This may be achieved, e.g., by determining an acoustic energy ramp-down time of the acoustic pulse, and classifying the acoustic pulse as an electrical abnormality only if the acoustic energy ramp-down time is below a maximum acoustic energy ramp-down threshold value. When defined as a period of time from a first point in time at which the energy content of the acoustic pulse reaches its maximum value to a second point in time at which the energy content of the pulse falls below the energy content threshold value, the maximum acoustic energy ramp-down threshold value may, for example, be set to a value in the range of 10-40 ms. Preferably, the maximum acoustic energy ramp-down threshold value should be at most 30 ms, even more preferably at most 20 ms, and most preferably at most 10 ms.

The method may further comprise the step of generating an alarm signal and/or automatically switching off the electrical equipment in response to classifying the occurrence of the acoustic pulse as an electrical abnormality. In this way, a user may be notified about the occurrence of electrical abnormalities in the electrical equipment, and/or the electrical equipment may be switched off upon detection of electrical abnormalities, thereby preventing or at least mitigating the risk of severe damages to the electrical equipment and the surroundings of the electrical equipment.

The method may be used for detection of electrical abnormalities in association with any type of electrical equipment, including but not limited to electrical equipment in electrical cabinets, fuse boxes, switchboards and racks, electrical home appliances, electrical connectors, and electrical cables. The sound of the electrical equipment may, for example, be picked up by the acoustic sensor device from a mounting rail for electrical equipment onto which the acoustic sensor device is mounted, an electrical cable onto which the acoustic sensor device is mounted, or an electrical connector onto or into which the acoustic sensor device is mounted or integrated.

The above-described method is typically a computer-implemented method that may be performed upon execution of a computer program by one or more processors of a system for detection of electrical abnormalities in association with electrical equipment.

Thus, according to another aspect of the present disclosure there is provided a computer program comprising computer-readable instructions which, when executed by at least one processor of a system for detection of electrical abnormalities in association with electrical equipment, causes the at least one processor to perform the steps of:
- receiving acoustic signals reflecting sound of the electrical equipment during normal operation thereof, registered during a calibration process by an acoustic sensor device that is operatively coupled to the at least one processor;
- determining an energy content threshold value for acoustic signals within a frequency band to be monitored during monitoring of the electrical equipment following the calibration process, based on the acoustic signals registered within that frequency band during the calibration process;
- detecting, among the acoustic signals registered by the acoustic sensor device during monitoring of the electrical equipment following the calibration process, an acoustic pulse within said frequency band, and
- classifying the acoustic pulse as an electrical abnormality associated with the electrical equipment when an energy content of the acoustic pulse exceeds the energy content threshold value.

The computer program may further comprise instructions for causing the at least one processor of the system to perform any of, or any combination of, the method steps of the above described method.

The computer program may reside entirely in the acoustic sensor device or it may be a distributed computer program partly residing in the acoustic sensor device and partly residing in a network server to which the acoustic sensor device is communicatively connectable. The computer program may comprise several computer program components configured to perform different steps of the above described method. For instance, the computer program may comprise a first program component or application for data processing and communication residing in the acoustic sensor device, a second program component or application for data analysis and data communication residing in the network server, and a third program component or application in form of a client application for presentation of data and interaction with a user, residing in an electronic device of the user. The client application may, for example, be realized in form of a mobile application (app) configured to be run on a mobile electronic device, such as a mobile phone or a tablet computer.

According to another aspect of the present disclosure there is provided a computer program product comprising at least one computer-readable medium, such as a non-volatile memory, storing the above mentioned computer program.

According to yet another aspect of the present disclosure there is provided a system for detection of electrical abnormalities in association with electrical equipment. The system comprises an acoustic sensor device for registering acoustic signals reflecting sound of the electrical equipment, and at least one processor operatively coupled to the acoustic sensor device. The at least one processor is configured to:
- receive acoustic signals registered by the acoustic sensor device during a calibration process;
- determining an energy content threshold value for acoustic signals within a frequency band to be monitored during monitoring of the electrical equipment following the calibration process, based on the acoustic signals registered within that frequency band during the calibration process;
- detecting, among the acoustic signals registered by the acoustic sensor device during monitoring of the electrical equipment following the calibration process, an acoustic pulse within said frequency band, and
- classifying the acoustic pulse as an electrical abnormality associated with the electrical equipment when an energy content of the acoustic pulse exceeds the energy content threshold value.

Preferably, the frequency band should have a bandwidth of at most 100 Hz, preferably at most 75 Hz, and even more preferably at most 50 Hz. A suitable centre frequency of the frequency band may, in some applications, be approximately 1 kHz or 4,5 kHz.

The frequency band may be preset or determined by the at least one processor based on the acoustic signals registered by the acoustic sensor device during the calibration process.

In some embodiments, the at least one processor is configured to compare energy contents of different frequencies of the acoustic signals registered by the acoustic sensor device during the calibration process, and determine the frequency band to be monitored as a frequency band having a relatively low energy content, based on the comparison.

The at least one processor may further be configured to determine a pulse duration time of the acoustic pulse, and classify the acoustic pulse as an electrical abnormality only when the pulse duration time is below a maximum pulse duration threshold value. For example, the at least one processor may be configured to determine the pulse duration time as a period of time during which the energy content of the acoustic pulse exceeds the energy content threshold value, wherein the maximum pulse duration threshold value may be set in the range of 15-50 ms. Preferably, the maximum pulse duration threshold value should be at most 40 ms, even more preferably at most 30 ms, and most preferably at most 20 ms.

The processor may further be configured to classify the acoustic pulse as an electrical abnormality based on a rate of increase and/or a rate of decrease of the energy content of the acoustic pulse.

In some embodiments, the at least one processor is configured to determine a measure indicative of a rate of increase of energy content of the acoustic pulse, and to classify the acoustic pulse as an electrical abnormality only when the measure of the rate of increase exceeds a set threshold value. To this end, the at least one processor may be configured to determine an acoustic energy ramp-up time of the acoustic pulse, and to classify the acoustic pulse as an electrical abnormality only if the acoustic energy ramp-up time is below a maximum acoustic energy ramp-up threshold value. The at least one processor may be configured to determine the acoustic energy ramp-up time as a period of time from a first point in time at which the energy content of the acoustic pulse exceeds the energy content threshold value to a second point in time at which the energy content of the acoustic pulse reaches its maximum value, and to use a maximum acoustic energy ramp-up threshold value in the range of 10-40 ms. Preferably, the maximum acoustic energy ramp-up threshold value should be at most 30 ms, even more preferably at most 20 ms, and most preferably at most 10 ms.

Likewise, in some embodiments, the at least one processor may be configured to determine a measure indicative of a rate of decrease of energy content of the acoustic pulse, and to classify the acoustic pulse as an electrical abnormality only when the measure of the rate of decrease exceeds a set threshold value. To this end, the at least one processor may be configured to determine an acoustic energy ramp-down time of the acoustic pulse, and to classify the acoustic pulse as an electrical abnormality only if the acoustic energy ramp-down time is below a maximum acoustic energy ramp-down threshold value. The at least one processor may be configured to determine the acoustic energy ramp-down time as a period of time from a first point in time at which the energy content of the acoustic pulse reaches its maximum value to a second point in time at which the energy content of the pulse falls below the energy content threshold value, and to use a maximum acoustic energy ramp-down threshold value in the range of 10-40 ms. Preferably, the maximum acoustic energy ramp-down threshold value should be at most 30 ms, even more preferably at most 20 ms, and most preferably at most 10 ms.

The at least one processor may also be configured to generate an alarm signal and/or to automatically switch off the electrical equipment in response to classifying the acoustic pulse as an electrical abnormality. In some embodiments the alarm may be generated locally by the acoustic sensor device, e.g. in the form of an audible and/or visual alarm for alerting a local user. Instead or in addition to a local alarm, the at least one processor may be configured to generate an alarm signal that is provided to the user via an electronic device of the user, which electronic device is operatively coupled to the acoustic sensor device, e.g. via a network server. In some embodiments, the alarm signal may be provided to the user via a mobile application for detection of electrical abnormalities in association with electrical equipment, configured to be run on a mobile electronic device of the user, such as a mobile phone or a tablet computer.

In some embodiments, the acoustic sensor device may be configured to pick up the sound of the electrical equipment from a mounting rail for electrical equipment onto which the acoustic sensor device is mounted, an electrical cable onto which the acoustic sensor device is mounted, or an electrical connector onto or into which the acoustic sensor device is mounted or integrated.

The present disclosure will become apparent from the detailed description given below. The detailed description and specific examples disclose preferred embodiments of the disclosure by way of illustration only. Those skilled in the art understand from guidance in the detailed description that changes and modifications may be made within the scope of the appended claims.

### BRIEF DESCRIPTIONS OF THE DRAWINGS

The above objects, as well as additional objects, features and advantages of the present disclosure, will be more fully appreciated by reference to the following illustrative and non-limiting detailed description of example embodiments of the present disclosure, when taken in conjunction with the accompanying drawings, of which:
Figure 1A illustrates an exemplary embodiment of an acoustic sensor device attached to a mounting rail;
Figure 1B illustrates some internal components of an exemplary embodiment of an acoustic sensor device 30;
Figures 2A-C illustrate exemplary embodiments of an acoustic sensor device attached to a mounting rail;
Figure 3 illustrates an exemplary embodiment of an acoustic sensor device attached to a mounting rail;
Figure 4 illustrates an exemplary embodiment of a system for detecting electrical abnormalities in association with electrical equipment according to an exemplary embodiment of the disclosure;
Figures 5A-5B illustrate a power spectrum of background noise registered by the acoustic sensor device during calibration of a system for detecting electrical abnormalities in association with electrical equipment;
Figure 5C illustrates a power spectrum of the background noise and an acoustic pulse caused by an electrical abnormality associated with the electrical equipment, registered by the acoustic sensor device during monitoring of the electrical equipment;
Figures 5D-5E illustrates an energy content of the acoustic pulse in a monitored frequency band, as a function of time;
Figure 6A is a flow chart illustrating an exemplary embodiment of a method for detection of electrical abnormalities in association with electrical equipment;
Figure 6B is a flow chart illustrating some steps of a calibration process of the method illustrated in figure 6A, according to an exemplary embodiment of the present disclosure, and
Figure 6C is a flow chart illustrating some steps of a monitoring phase of the method illustrated in figure 6A, according to an exemplary embodiment of the present disclosure.

### DETAILED DESCRIPTION

The present disclosure will now be described with reference to the accompanying drawings, in which preferred example embodiments of the disclosure are shown. The disclosure may, however, be embodied in other forms and should not be construed as limited to the herein disclosed embodiments. The disclosed embodiments are provided merely to fully convey the scope of the disclosure to the skilled person.

It is to be understood that the terminology used herein is for purpose of describing particular embodiments only, and is not intended to be limiting. It should be noted that, as used in the specification and the appended claims, the articles "a", "an", "the", and "said" are intended to mean that there are one or more of the elements unless the context explicitly dictates otherwise. Thus, for example, reference to "a unit" or "the unit" may include several devices, and the like. Furthermore, the terms "comprising", "including", "containing" and similar wordings are intended to be open-ended transitional terms that do preclude the possibility of additional elements or steps.

It should be appreciated that the method, computer program and system described hereinafter may be used for detection of electrical abnormalities in association with any type of electrical equipment, including but not limited to electrical equipment in electrical cabinets, fuse boxes, switchboards and racks, electrical home appliances, electrical connectors, and electrical cables. The acoustic sensor device of the system could be placed on, near, or in, various types of electrical equipment in order to detect electrical abnormalities, such as arcing or abnormal heat generation, in association with the electrical equipment, and to alert and/or switch off electricity upon detection of any such abnormality. For example, the acoustic sensor device of the system may be mounted onto a mounting rail of an electrical cabinet for monitoring the electrical equipment of a facility, such as a household or office building; attached to an electrical cable, such as a high-voltage cable, for monitoring the electrical condition of the cable; integrated into an electrical connector, such as a wall outlet power plug, wall outlet plug-in adapter or power strip, for monitoring electrical equipment connected to the electrical grid via the electrical connector, e.g., during use or charging of the electrical equipment.

In the following, however, as a non-limiting example, the acoustic sensor device will be described in the context of a system for detection of electrical abnormalities in association electrical equipment in an electrical cabinet, and, in particular, an electrical cabinet comprising one or more mounting rails onto which the electrical equipment is mounted.

One known standard mounting rail is the so called DIN rail, which is a metal rail used all over the world. There are three different types of DIN rails, one with a so called "top hat section", one with C section and one with G section. The top hat section, with a hat-shaped cross section will herein also be referred to as having a somewhat U-shaped cross section. The DIN rails thus comes in various shapes and sizes with different depths but they typically comprise upper and lower flanges. In some embodiments, the acoustic sensor device for registering the acoustic signals reflecting the sound generated by the electrical equipment may be configured to be mounted on a DIN rail.

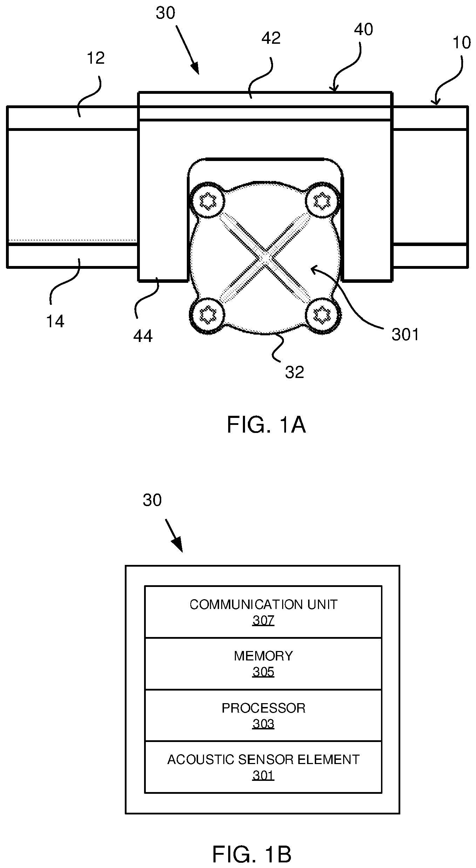

Figure 1A schematically illustrates an exemplary embodiment of an acoustic sensor device 30, when attached to a mounting rail 10, such as a DIN rail. The sensor device 30 comprises a housing 32 and an acoustic sensor element 301 arranged inside the housing 32 to register acoustic signals reflecting sound generated by electrical equipment in the vicinity of the sensor device 30 and propagating towards the sensor device 30 via the mounting rail 10. The acoustic sensor element 301 is operatively connectable to at least one processor that is configured to detect electrical abnormalities in association with the electrical equipment based on the acoustic signals registered by the acoustic sensor element 301. The at least one processor to which the sensor element 301 is connectable may be comprised in the sensor device 30 or it may be an external processor. The sensor device 30 may further comprise an attachment arrangement 40 for detachable attachment to the mounting rail 10.

Figure 1B illustrates some internal components of an exemplary embodiment of the acoustic sensor device 30. In this example, the sensor device 30 comprises an acoustic sensor element 301, a processor 303, a memory 305, and a communication unit 307, all of which are arranged inside the housing 32. It is, however, to be understood that the at least one processor 303, the memory 305 and/or the communication unit 307 may as well be arranged external to the housing 32. In some embodiments (not shown), the acoustic sensor element 301 is connectable via a wired or wireless connection to an external control module that accommodates the processor 303, the memory 305, and the communication unit 307. The control module may also be equipped with an attachment arrangement for detachable attachment of the control module to the mounting rail 10. In such a scenario, the sensor device 30 can be said to constitute a dual-module sensor device comprising a first mounting rail module including the acoustic sensor element 301, and a second mounting rail module including the processor and possibly additional components for data processing and/or communication.

The acoustic sensor element 301 of the sensor device 30 is configured to register acoustic signals reflecting the sound generated by nearby electrical equipment. The sound may manifest itself in form of structure-borne sound or vibrations in the mounting rail 10, which vibrations are picked up by the sensor element 301 and converted by the acoustic sensor element 301 to electrical signals. In some embodiments, the acoustic sensor element 301 may comprise a piezoelectric sensor element. In some embodiments, the acoustic sensor element 301 may be a contact microphone for registering structure-borne sound in the mounting rail 10.

The processor 303 is configured to detect electrical abnormalities associated with the nearby electrical equipment based on the acoustic signals registered by the sensor element 301 of the sensor device 30. This is achieved by the processor 303 upon execution of a computer program stored in the memory 305. The memory 305 may be integrated with or embedded into the at least one processor 303, or be a separate memory hardware device. The memory may include a random access memory (RAM), a read-only memory (ROM), a hard disk, an optical disk, a magnetic medium, a flash memory or any other mechanism capable of storing instructions or data. The processor 303 may include any physical device having an electric circuit that performs logic operations on input data. For example, the processor 303 may include one or more integrated circuits, microchips, microcontrollers, microprocessors, all or part of a central processing unit (CPU), digital signal processor (DSP), field-programmable gate array (FPGA), or other circuits for executing instructions or performing logic operations. Unless stated otherwise, it should be realized that actions and method steps described hereinafter are performed by the processor 303 upon execution of the computer program stored in the memory 305.

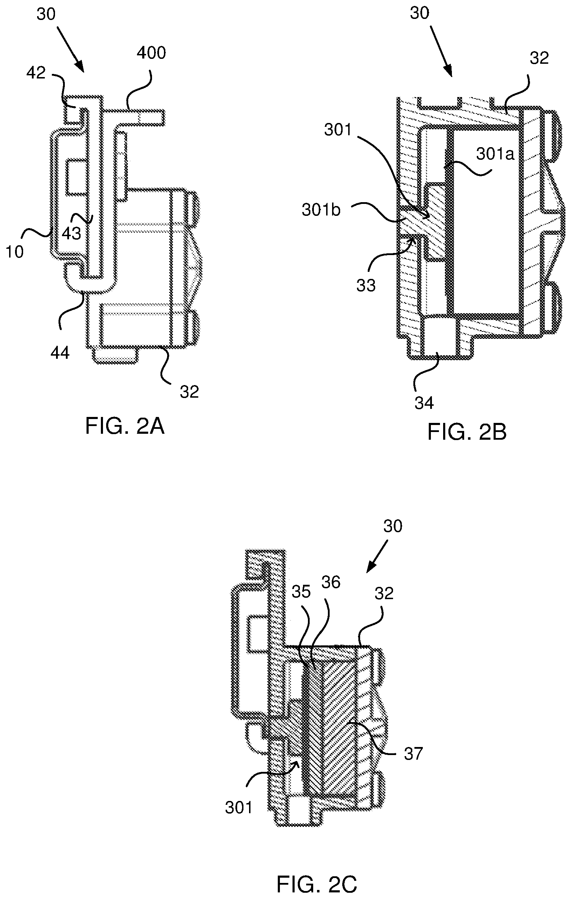

Before going into details of the method for detection of electrical abnormalities, some exemplary embodiments of an acoustic sensor device 30 configured to be attached to a mounting rail will now be described with reference to Figures 2A-2C.

Figure 2A illustrates an example where the attachment arrangement 40 of the acoustic sensor device 30 comprises an upper connection portion 42 and a lower connection portion 44. The upper connection portion 42 of the attachment arrangement 40 may be configured to interact with an upper flange 12 of the mounting rail 10, and the lower connection portion 44 may be configured to interact with a lower flange 14 of the mounting rail 10. The attachment arrangement 40 may comprise a snap-fit connection. The snap-fit connection may be shaped to easily snap the sensor device 30 onto the mounting rail 10. The snap-fit connection may comprise the upper connection portion 42 and the lower connection portion 44. The attachment arrangement 40 may be somewhat resilient, such that it allows minor deformation of the upper 42 and lower 44 connection portion in order to attach the sensor device 30 on the mounting rail 10.

The attachment arrangement 40 of the acoustic sensor device 30 may comprise an adjustable clamping element 400. The adjustable clamping element 400 may comprise the lower connection portion 44 of the attachment arrangement 40. The upper connection portion 42 of the attachment arrangement 40 may be hook shaped, such that it can be hanged over an upper flange 12 of the mounting rail 10. The lower connection portion 44 may also be hook shaped to engage the lower flange 14 of the mounting rail 10.

The upper connection portion 42 may in one example form part of an attachment plate 43 connected to, or integrated with, the housing 32 of the sensor device 30. The adjustable clamping element 400 may be movably arranged in relation to the attachment plate 43. The clamping element 400 can thereby be moved to adjust the distance between the upper connection portion 42 and the lower connection portion 44 of the attachment arrangement 40. This way, mounting of the sensor device 30 on the mounting rail 10 is facilitated. The clamping element 400 may be attached to the attachment plate 43 by means of fasteners, which are loosened in order to allow displacement of the clamping element 400.

Figure 2B schematically illustrates a cross-sectional view of the sensor device 30 according to an example. The figure shows the housing 32 and the acoustic sensor element 301 arranged inside the housing 32. In this example, the acoustic sensor element 301 comprises a piezoelectric sensor element 301a and a protrusion 301b. The protrusion 301b and the piezoelectric sensor element 301a are arranged in abutment with each other. In some embodiments, the acoustic sensor element may be a contact microphone for registering structure-borne sound in the mounting rail.

The protrusion 301b is adapted to extend through an aperture 33 in the housing 32 to abut the mounting rail 10 during operation of the acoustic sensor device 30. When the sensor device 30 is mounted onto the mounting rail 10, the protrusion 301b presses against the mounting rail 10 and can thereby register sound and vibrations propagating in the mounting rail. The protrusion 301b may be movably arranged inside the housing 32. The protrusion 301b may be a probe or other device configured to convey vibrations to the piezoelectric sensor element 301a.

The sensor device 30 is typically configured such that the acoustic sensor element 301 abuts a flange section of the mounting rail 10. The aperture 33 of the housing 32 may thus be arranged to face a flange section of the mounting rail 10 when the sensor device 30 is arranged on the mounting rail 10. The aperture 33 is suitably arranged at a predetermined position corresponding to the position of the lower flange 14 of the mounting rail 10.

Figure 2B further shows a connection opening 34 in the housing 32 through which an electrical cable may extend to connect the acoustic sensor element 301 with the at least one processor 303.

Figure 2C schematically illustrate a cross-section view of the sensor device 30 according to an example. In this example, the sensor device 30 further comprises a protective sheet 35 arranged adjacent the acoustic sensor element 301 inside the housing 32. The protective sheet 35 is arranged to protect the acoustic sensor element 301 from any electrical interference. The protective sheet 35 may comprise a plastic film. In the event that the acoustic sensor element 301 comprises a piezoelectric element 301a, the protective sheet 35 may be arranged in abutment with the piezoelectric element 301a.

The sensor device 30 may also comprise a dampening element 36 arranged in connection with the acoustic sensor element 301. The dampening element 36 may be referred to as a weight, and is arranged to reduce vibrations and oscillations in the acoustic sensor element 301 itself. The dampening element 36 may comprise metal. The dampening element 36 is here arranged adjacent the protective sheet 35. Thus, the protective sheet 35 may be arranged between the acoustic sensor element 301 and the dampening element 36.

Furthermore, the sensor device 30 may comprise a pressure part 37 arranged to apply a pressure on the acoustic sensor element 301. The pressure part 37 may be biased and will thereby apply a force on the acoustic sensor element 301, such that the acoustic sensor element 301, 301a, is pressed against the mounting rail 10. The pressure part 37 may comprise a spring element, rubber or similar. The biased pressure part 37 may be arranged in abutment with the dampening element 36, the protective sheet 35 or the acoustic sensor element 301.

It is to be understood that even through this figure shows the protective sheet 35, the dampening element 36 and the pressure part 37 all arranged inside the hosing 32, the sensor device 30 may comprise only one or two of these components.

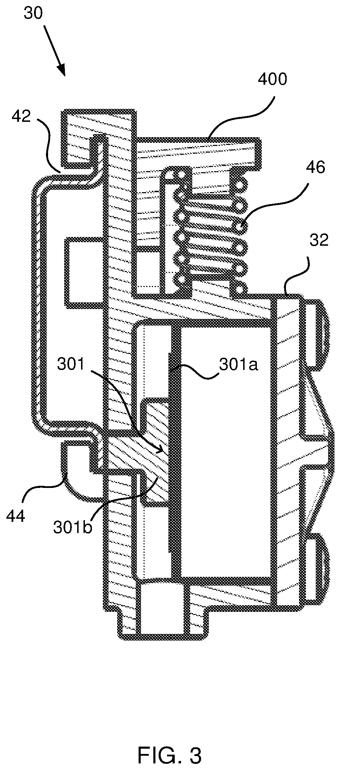

Figure 3 schematically illustrates an exemplary embodiment of a sensor device 30 attached to a mounting rail 10 according to the present disclosure. The sensor device 30 may be configured as disclosed in any of the figures 1A-B or 2A-C.

I this example, the attachment arrangement 40 further comprises a spring element 46 arranged to apply a spring force on the movable clamping element 400 in direction towards the upper connection portion 42. The spring element 46 may be arranged between the housing 32 and the clamping element 400. Thus, in order to increase the distance between the upper and lower connection portions 42, 44, the clamping element 400 is moved in a direction opposite to the spring force, thereby compressing the spring element 46. When the sensor device 30 is arranged on the mounting rail 10, the spring element 46 ensures that the clamping element 400 is moved upwards, such that the lower connection portion 44 presses against the lower flange 14 of the mounting rail 10.

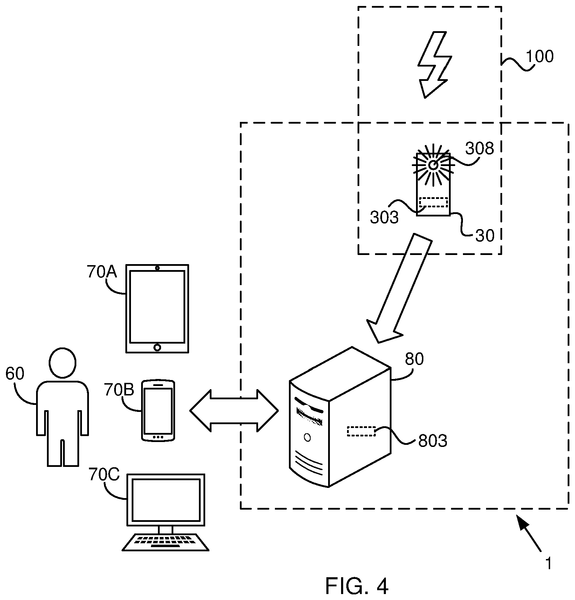

Figure 4 illustrates a system 1 for detection of electrical abnormalities in association with electrical equipment, generally denoted by reference numeral 100 in the figure, according to an exemplary embodiment of the present disclosure.

As mentioned above, the method, computer program and system for detection of electrical abnormalities in association with electrical equipment are not limited to any particular type of electrical equipment. Nor are they limited to any particular type of acoustic sensor device for registering the acoustic signals reflecting the sound of the electrical equipment. Consequently, it should be realized that the method, computer program and system is not limited to the use of an acoustic sensor device that is configured to be mounted onto a mounting rail for electrical equipment. Instead it should be realized that the method, computer program and system of the present disclosure may be used with any type of acoustic sensor device capable of registering acoustic signals reflecting the sound of electrical equipment, including but not limited to acoustic sensor devices arranged to pick up airborne sound of electrical equipment, electrical cable or wire borne sound of electrical equipment, or sound picked up from any medium through which sound generated by electrical equipment can propagate to the acoustic sensor device.

The system 1 comprises an acoustic sensor device 30 for registering acoustic signals reflecting the sound generated by the electrical equipment. The system 1 further comprises at least one processor 303, 803 that is configured to detect electrical abnormalities associated with the electrical equipment based on the acoustic signals registered by the acoustic sensor device 30, as will be described in more detail below. The system 1 is further configured to generate an alarm signal and/or to automatically switch off the electrical equipment upon detection of electrical abnormalities in association with the electrical equipment.

In some embodiments, the system 1 may be configured to generate a local alarm upon detection of electrical abnormalities in association with the electrical equipment. To this end, the acoustic sensor device 30 may comprise means for generating an audible and/or visible alarm signal to a local user, such as an audible signal generator and/or a light indicator 308.

In some embodiments, such as the exemplary embodiment illustrated in figure 4, the system 1 may be configured to alert a remote user 60 upon detection of electrical abnormalities in association with the electrical equipment by causing an alert to be displayed on an electronic device of the user, such as a portable electronic device in form of, e.g., a tablet computer 70A or a mobile phone 70B, or a portable or stationary computer 70C.

In the latter scenario, the acoustic sensor device 30 may be operatively connected to a network server 80, which, in turn, may be configured to communicate information relating to the detection of electrical abnormalities to the one or more electronic devices 70A-70C of the user 60. The network server 80 may, e.g., be a cloud server connected to the Internet, and the communication unit (307 in Fig. 1B) of the acoustic sensor device 30 may be configured to communicate with the network server using any known communications protocol.

The functionality for detection of electrical abnormalities in association with the electrical equipment may reside in any or both of the acoustic sensor device 30 and the network server 80. When residing in the network server 80, the acoustic signals or characteristics of the acoustic signals registered by the acoustic sensor device 30 may be transmitted to the network server, whereupon a processor 803 of the network server processes the signals or the characteristics of the signals in accordance with the principles described below. Any detection of electrical abnormalities may then be communicated by the network server 80 to the acoustic sensor device 30 for generation of a local alarm, and/or to the one or more electronic devices 70A-70C of the user for generation of a remote alarm on the electronic device. When residing in the acoustic sensor device 30, the acoustic signals registered by the acoustic sensor device 30 may be processed locally by the processor 303 of the sensor device in accordance with the principles described below, whereupon the sensor device 30 may communicate any detection of electrical abnormalities to the network server 80, in order for the network server 80 to alert the user 60 of the detection of electronic abnormalities via the one or more electronic devices 70A-70C of the user.

The at least one processor 303, 803 of the system 1 may be configured to detect the electrical abnormalities by determining whether an energy content of the registered acoustic signals exceeds an energy content threshold value, indicating that that an electrical abnormality has occurred.

More specifically, the at least one processor 303, 803 may be configured to receive acoustic signals registered by the acoustic sensor device 30 during a calibration process, which acoustic signals indicate a background noise generated by the electrical equipment and, perhaps, other electrical and non-electrical objects in the surroundings of the acoustic sensor device. In some embodiments, the calibration process may last for a predetermined period of time, e.g., an hour or a day. In other embodiments, the calibration process may last until acoustic signals having an energy content exceeding the energy content of previously registered acoustic signals have not been registered for a certain period of time.

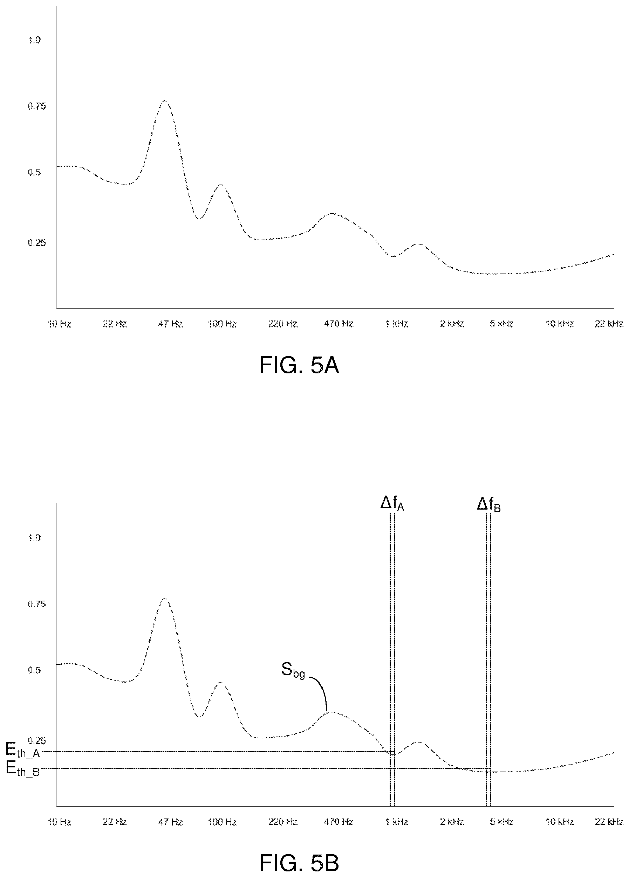

Figure 5A is a power spectrum illustrating a signal representing the energy spectral density of background noise registered by the acoustic sensor device 30 during the calibration process. In this example, the background noise was registered during a real testing scenario with an acoustic sensor device 30 that was mounted onto a mounting rail of an electrical cabinet. The power spectrum shows that the energy content of the background noise is high for frequencies at or near the mains frequency of 50 Hz. The diagram also shows that the energy content is high for frequencies below 50 Hz, which may be due, e.g., to nearby fans, pumps or compressors operating at low frequencies, or even vibrations from people walking in the surroundings. The diagram also shows that, in this exemplary scenario, the energy content of the background noise is relatively high in frequencies around 100 Hz, 470 Hz and 1,3 kHz. It can also be noted that the energy content of the background noise tends to decrease from a relatively high energy content for low frequencies towards a minimum energy content for frequencies of approximately 4-5 kHz, whereafter the energy content starts to increase again for frequencies over 5 kHz.

The acoustic signals registered by the acoustic sensor device 30 during the calibration process is used by the at least one processor 303, 803 to determine an energy content threshold value to be used for detection of electrical abnormalities during subsequent monitoring of the electrical equipment in a monitoring phase following the calibration process. The energy content threshold value is determined for at least one specific frequency band to be monitored during the monitoring phase, and is determined based on the acoustic signals registered within that specific frequency band during the calibration process. Preferably, the energy content threshold value is set to a value slightly above the energy content of the background noise registered within the frequency band during the calibration process, e.g., slightly above a maximum energy content of any acoustic signal registered within that frequency band during the calibration process.

The at least one processor 303, 803 is further configured to detect an acoustic pulse among the acoustic signals registered by the acoustic sensor device 30 during the monitoring phase, within the monitored frequency band (corresponding to the above mentioned frequency band to be monitored), and to classify the acoustic pulse as an electrical abnormality associated with the electrical equipment when an energy content of the acoustic pulse exceeds the energy content threshold value.

The frequency band to be monitored should preferably be selected to exclude high-energy content acoustic signals generated by the electrical equipment during normal operation thereof, i.e. to exclude frequencies where the energy content of the background noise is high. This allows the energy content threshold value to be set to a relatively low value, thereby increasing sensitivity in the detection of electrical abnormalities.

Preferably, the frequency band should be narrow enough to exclude both expected background noise and unexpected acoustic activity in the surroundings of the acoustic sensor device. In most applications, the frequency band should have a bandwidth of at most 200 Hz. Preferably, the frequency band should have a bandwidth of at most 100 Hz, more preferably at most 75 Hz, and even more preferably at most 50 Hz.

The frequency band may be preset, either as a default frequency band or as a user-defined frequency band, selected based on the type of electrical equipment to be monitored and/or the surroundings of the electrical equipment to be monitored.

In some embodiments, however, the frequency band to be monitored may be determined by the at least one processor 308, 803 based on the acoustic signals registered by the acoustic sensor device during the calibration process, i.e., based on the background noise registered during calibration. For example, the at least one processor 308, 803 may be configured to compare energy contents of different frequencies of the acoustic signals registered by the acoustic sensor device during the calibration process, and determine the frequency band to be monitored as a frequency band having a relatively low energy content, based on the comparison. The at least one processor 308, 803 may also be configured to take an expected power spectrum of an electrical pulse caused by an electrical abnormality, e.g., the formation of a spark, into account in the determination of the frequency band to be monitored. For example, the at least one processor 308, 803 may be configured to determine a frequency band to be monitored based on a difference between the power spectrum of the background noise registered during the calibration process and an expected power spectrum of an electrical pulse caused by an electrical abnormality associated with the electrical equipment. In some embodiments, the at least one processor 308, 803 may be configured to determine the frequency band to be monitored as a frequency band in which a difference between the energy content of the acoustic signals registered during the calibration process (i.e., the background noise) and an expected energy content of an electrical pulse caused by an electrical abnormality associated with the electrical equipment exceeds a predetermined threshold value. In other words, the at least one processor 308, 803 may be configured to determine the frequency band to be monitored based on a signal-to-noise ratio (SNR) for different frequencies of an expected power spectrum of an acoustic pulse caused by any electrical abnormality associated with the electrical equipment. This way, the energy content of an electrical pulse caused by an electrical abnormality can be expected to well exceed the energy content threshold value, thereby providing for robust detection of electrical abnormalities.

In some embodiments, the at least one frequency band to be monitored during the monitoring process is a single frequency band.

In other embodiments, the at least one frequency band to be monitored during the monitoring process may comprise two of more distinct frequency bands that are preset or determined by the at least one processor 308, 803 in accordance with the above-described principles. In this scenario, the at least one processor 308, 803 may be configured to determine a separate energy content threshold value for each frequency band to be monitored, and to classify an acoustic pulse registered during the monitoring phase as an electrical abnormality only when the energy content of the acoustic pulse exceeds the energy content threshold value of each of the monitored frequency bands. This way, an acoustic pulse caused by electrical abnormalities associated with the electrical equipment can be distinguished from acoustic activity giving rise to acoustic pulses having similar characteristics as the acoustic pulse caused by the electrical abnormality in one of the monitored frequency bands, thereby providing for even more robust detection of electrical abnormalities.

Once the calibration process is over and the monitoring phase has commenced, the at least one processor 303, 308 is operative to detect electrical abnormalities associated with the electrical equipment based on the acoustic signals registered by the acoustic sensor 30 device during the monitoring phase and at least one energy content threshold value determined from the acoustic signals registered during the calibration process. More specifically, the at least one processor 303, 803 is configured to detect an acoustic pulse among the acoustic signals registered by the acoustic sensor device 30 during the monitoring phase, within the monitored frequency band, and to classify the acoustic pulse as an electrical abnormality associated with the electrical equipment when an energy content of the acoustic pulse exceeds the energy content threshold value.

Detection and classification of an electrical pulse as an electrical abnormality associated with the electrical equipment will now be described in more detail with reference to figures 5B-5D.

Figure 5B is a diagram illustrating the power spectrum of the background noise shown in figure 5A, including a first frequency band Δf_{A} and a second frequency band Δf_{B} associated with a respective energy content threshold value E_{th_A} and E_{th_B}. The at least one processor 303, 803 may be configured to monitor any or both of the first and second frequency band Δf_{A}, Δf_{B} during monitoring of the electrical equipment in the monitoring phase. The at least one frequency band Δf_{A}, Δf_{B} to be monitored may be preset or determined by the at least one processor 303, 803 in accordance with the above-described principles. In this example, the first frequency band Δf_{A} has a bandwidth of 50 Hz and a centre frequency of about 1 kHZ, and the second frequency band Δf_{B} has a bandwidth of 50 Hz and a centre frequency of about 4,5 kHZ. The second frequency band Δf_{B} having a centre frequency of approximately 4,5 kHz has been found to be a suitable frequency band for monitoring of standard electrical equipment of a typical electrical cabinet by means of an acoustic sensor device 30 mounted onto a mounting rail of the cabinet. The first frequency band Δf_{A} having a centre frequency of approximately 1 kHz is a frequency band that was found by the at least one processor 303, 803 to be particularly suitable for monitoring of the electrical equipment in the specific testing environment, using the above described principles for frequency band determination.

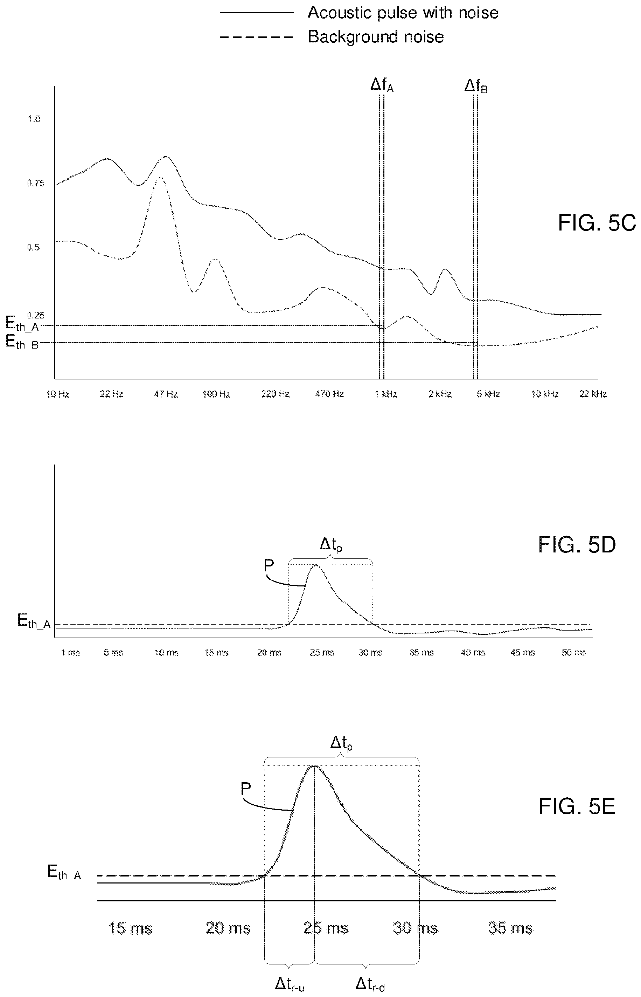

Figure 5C is a diagram showing the power spectrum of the background noise (dashed line), as illustrated in figure 5A, and a second power spectrum (solid line) illustrating the energy spectral density of an acoustic pulse caused by an electrical abnormality associated with the electrical equipment, such as the formation of a spark, when registered along with the background noise by the acoustic sensor device 30 during the monitoring phase. As clear from the figure, the energy content of the acoustic pulse is relatively evenly distributed in the frequency range of 5 Hz to 5 kHz.

When the energy content threshold value E_{th_A}, E_{th_B} of the at least one monitored frequency band Δf_{A}, Δf_{B} is exceeded, an acoustic pulse that is likely to be caused by an electrical abnormality associated with the electrical equipment has been detected and the at least one processor 303, 803 may be configured to classify the occurrence of the acoustic pulse as an electrical abnormality.

Now turning to the time domain, figure 5D illustrates the energy content of the acoustic pulse, P, as a function of time in first frequency band Δf_{A}. The duration Δt_{P} of acoustic pulses caused by electrical abnormalities, such as formation of sparks, is very short, and to distinguish a potentially damageable electrical abnormality from other types of acoustic activity registered by the acoustic sensor device 30, the at least one processor 303, 803 may be configured to determine the pulse duration time Δt_{P} of the acoustic pulse P, and to classify the acoustic pulse as an electrical abnormality only if the pulse duration time Δt_{P} is below a maximum pulse duration threshold value. The pulse duration time Δt_{P} may be defined as any measure of the duration in time of energy content of the acoustic pulse P. In the illustrated example, the pulse duration time Δt_{P} is defined as the period of time during which the energy content of the acoustic pulse P exceeds the energy content threshold value E_{th_A} for the monitored frequency band. With this definition, the pulse duration time Δt_{P} can be seen to be approximately 8 ms in the illustrated example. To prevent more durable acoustic activity to be mistaken for electrical abnormalities of the monitored electrical equipment, the maximum pulse duration threshold value may be set to a value in the range of 15-50 ms. Preferably, the maximum pulse duration threshold value should be at most 40 ms, even more preferably at most 30 ms, and most preferably at most 20 ms.

With reference now made to figure 5E, it has further been found that acoustic pulses generated by the above-mentioned types of electrical abnormalities have a very sudden increase and decrease in energy content. Therefore, to further prevent other acoustic activity from being mistaken for electrical abnormalities of the monitored electrical equipment, the at least one processor 303, 803 may be configured to determine a measure indicative of the rate of increase of energy content of the acoustic pulse P, and/or a measure indicative of the rate of decrease of energy content of the acoustic pulse P, and to classify the acoustic pulse P as an electrical abnormality only if the measure of the rate of increase and/or the measure of the rate of decrease exceeds a set threshold value.

For example, the at least one processor 303, 803 may be configured to determine a measure of the rate of increase in form of an acoustic energy ramp-up time Δtᵣ₋ᵤ for the acoustic pulse P. The acoustic energy ramp-up time Δtᵣ₋ᵤ may be defined as the duration between a first point in time at which the energy content of the acoustic pulse P exceeds the energy content threshold value E_{th_A}, and a second point in time at which the energy content of the acoustic pulse P reaches its maximum value. With this definition, the acoustic energy ramp-up time Δtᵣ₋ᵤ can be seen to be approximately 3 ms in the illustrated example. The at least one processor 303, 803 may be configured to classify the acoustic pulse as an electrical abnormality only if the acoustic energy ramp-up time Δtᵣ₋ᵤ is less than or equal to a maximum acoustic energy ramp-up threshold value. The maximum acoustic energy ramp-up threshold value may, e.g., be set to a value in the range of 10-40 ms. Preferably, the maximum acoustic energy ramp-up threshold value should be at most 30 ms, even more preferably at most 20 ms, and most preferably at most 10 ms.

Likewise, the at least one processor 303, 803 may be configured to determine a measure of the rate of decrease in form of an acoustic energy ramp-down time Δt_{r-d} for the acoustic pulse P. The acoustic energy ramp-down time Δt_{r-d} may be defined as the duration between a first point in time at which the energy content of the acoustic pulse P reaches its maximum value and a second point in time at which the energy content of the acoustic pulse P falls below the energy content threshold value E_{th_A}. With this definition, the acoustic energy ramp-down time Δt_{r-d} can be seen to be approximately 5 ms in the illustrated example. The at least one processor 303, 803 may be configured to classify the acoustic pulse as an electrical abnormality only if the acoustic energy ramp-down time Δt_{r-d} is less than or equal to a maximum acoustic energy ramp-down threshold value. The maximum acoustic energy ramp-down threshold value may, e.g., be set to a value in the range of 10-40 ms. Preferably, the maximum acoustic energy ramp-down threshold value should be at most 30 ms, even more preferably at most 20 ms, and most preferably at most 10 ms.

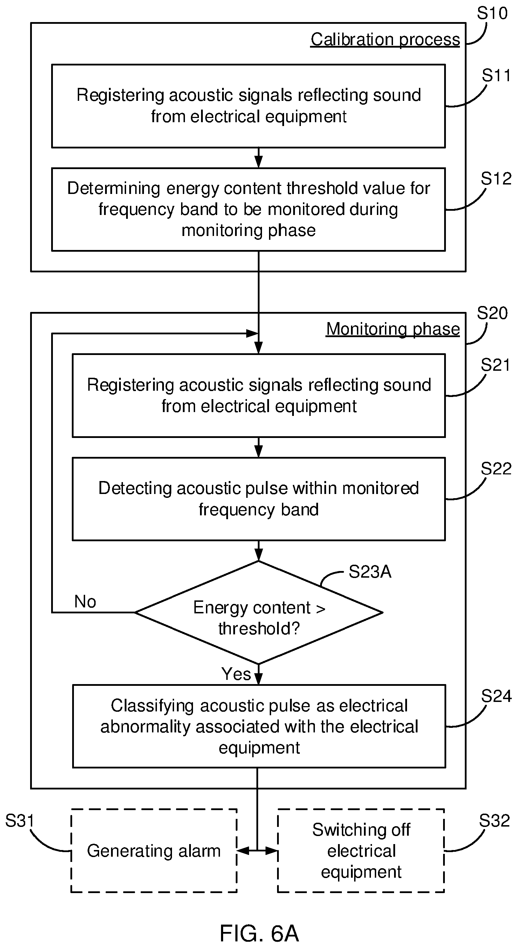

Figure 6A is a flow chart illustrating an exemplary embodiment of a method for detection of electrical abnormalities in association with electrical equipment. The method will be described below with simultaneous reference made to previous drawings.

In a first step S11 taking place during the calibration process S10, the acoustic sensor device 30 registers acoustic signals reflecting sound of the electrical equipment 100 during normal operation thereof. The acoustic signals registered during the calibration process S10 constitute a background noise which is expected by the system 1 to be present also during subsequent monitoring of the electrical equipment.

In a second step S12 which may also be part of the calibration process S10, an energy content threshold value E_{th_A}, E_{th_B} for acoustic signals within at least one frequency band Δf_{A}, Δf_{B} to be monitored during monitoring of the electrical equipment 100 following the calibration process is determined based on the acoustic signals registered within the at least one frequency band during the calibration process. The determination may be made by the at least one processor 303, 803 of the system 1.

After the calibration process S10, the system 1 is ready for continuous or intermittent monitoring or the electrical equipment 100. In a first step S21 of the monitoring phase S20, the acoustic sensor device 30 registers acoustic signals reflecting the sound of the electrical equipment 100. Although illustrated as a separate event in the flow chart, it should be realized that registration of acoustic signals may be performed continuously or intermittently throughout the entire monitoring phase.

In a second step S22 of the monitoring phase S20, an acoustic pulse P which may or may not be caused by an electrical abnormality associated with the electrical equipment 100 is detected among the acoustic signals registered by the acoustic sensor device 30, within the at least one monitored frequency band Δf_{A}, Δf_{B}. The detection of the acoustic pulse P may be made by the at least one processor 303, 803 of the system 1.

When an acoustic pulse is detected, the energy content of the acoustic pulse, within the monitored frequency band Δf_{A}, Δf_{B}, is compared in a step S23A with the energy content threshold value E_{th_A}, E_{th_B} determined in step S12. If the energy content exceeds the energy content threshold value E_{th_A}, E_{th_B}, the method proceeds to step S24 in which the acoustic pulse is classified as an electrical abnormality associated with the electrical equipment 100. If the energy content does not exceed the energy content threshold value E_{th_A}, E_{th_B}, the acoustic pulse P is not considered by the logic of the system 1 to be caused by an electrical abnormality, whereby the monitoring of the electrical equipment 100 through the continuous or intermittent registration of acoustic signals in step S21 can continue.

If the acoustic pulse P is classified as an electrical abnormality in step S24, the method continues to an "action phase" in which one or more actions are taken by the system 1 in response to the classification of the acoustic pulse as an electrical abnormality. As illustrated in the flow chart, the action phase may comprise an optional step S31 of generating an alarm. As discussed above, the alarm may be local alarm generated by the acoustic sensor device 30 on site, and/or a remote alarm for alerting a remote user of the detection of an electrical abnormality, e.g., via a mobile device of the user. Instead of, or in addition to, the step S31 of generating an alarm, the action phase may comprise a step S32 of switching off the electrical equipment 100. For example, the acoustic sensor device 30 or a separate switch device to which the acoustic sensor device 30 or the network server 80 is communicatively connected, may comprise means for mechanically and/or electrically cutting the power to the electrical equipment 100. In some embodiments, the means for cutting the power may include an actuator for mechanically actuating a main switch or main breaker of an electrical installation, such as a main switch or main breaker of an electrical cabinet or fuse box.

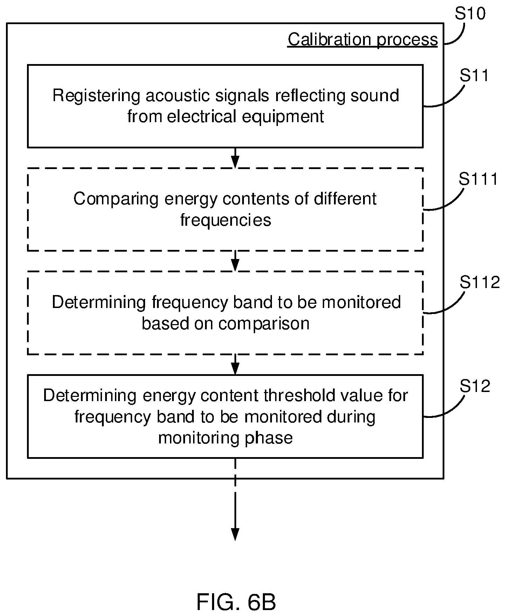

Figure 6B is a flow chart illustrating an example of a calibration process S10 according to an exemplary embodiment of the method illustrated in figure 6A.

In this exemplary embodiment, after registration of the acoustic signals reflecting sound of the electrical equipment during normal use thereof (step S11), the calibration process S10 comprises a step S111 of comparing energy contents of different frequencies of the acoustic signals, and a step S112 of determining the at least one frequency band Δf_{A}, Δf_{B} to be monitored during the monitoring phase S20 as a frequency band having a relatively low energy content, based on the comparison. Consequently, figure 6B illustrates an embodiment in which the system 1 is configured to automatically determine the at least one frequency band Δf_{A}, Δf_{B} to be monitored during monitoring of the electrical equipment 100 as a frequency band where the level of background noise is relatively low.

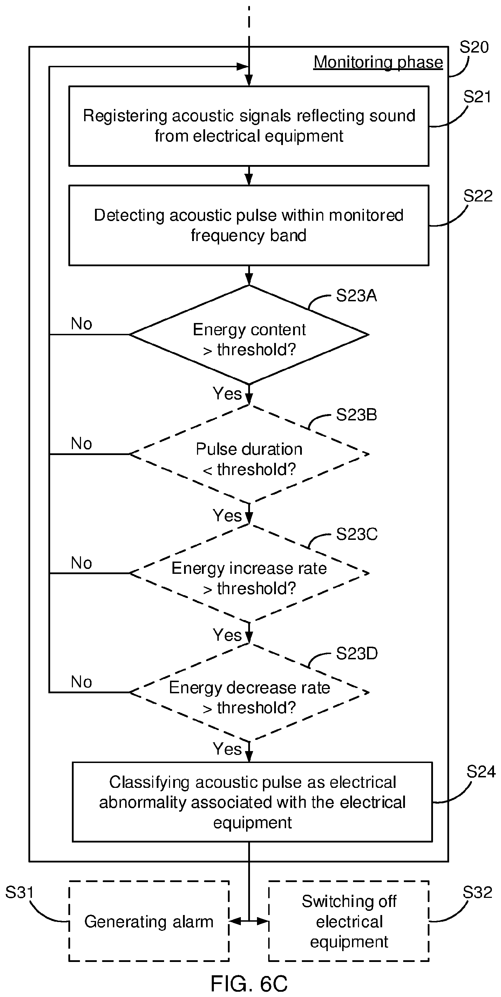

Figure 6C is a flow chart illustrating an example of a monitoring phase S20 according to an exemplary embodiment of the method illustrated in figure 6A.

In this exemplary embodiment, the electrical pulse P is not necessarily assumed to be caused by an electrical abnormality associated with the electrical equipment 100 just because the energy content of the acoustic pulse exceeds the the energy content threshold value E_{th_A}, E_{th_B} of the monitored frequency band Δf_{A}, Δf_{B}. Instead, the method includes one or more optional steps S23B-S23D that may be performed to further investigate the characteristics of the acoustic pulse in order to prevent other acoustic activities from being mistaken for an electrical abnormality associated with the electrical equipment 100.

For example, the method may comprise an optional step S23B of determining a pulse duration time Δtₚ of the acoustic pulse P, whereby the pulse is classified as an electrical abnormality in step S24 only if the pulse duration time Δtₚ is below a maximum pulse duration threshold value.

Instead or in addition to step S23B, the method may comprise an optional step S23C of determining a measure indicative of a rate of increase of energy content of the acoustic pulse P, whereby the pulse is classified as an electrical abnormality in step S24 only if the measure of the rate of increase exceeds a set threshold value.

Instead or in addition to steps S23B and S23C, the method may comprise an optional step S23D of determining a measure indicative of a rate of decrease of energy content of the acoustic pulse P, whereby the pulse is classified as an electrical abnormality in step S24 only if the measure of the rate of decrease exceeds a set threshold value.

As clear from the foregoing description, the method is typically a computer-implemented method performed by one or more processors 303, 803 of the system 1 upon execution of a computer program. As also clear from the foregoing description, the computer program may reside in the acoustic sensor device 30 or it may be a distributed computer program comprising program components residing in both the acoustic sensor device 30 and the network server 80. The method may hence be performed by the processor 303 of the acoustic sensor device 30 or in part by the processor 303 of the acoustic sensor device 30 and in part by the processor 803 of the network server 80.

The person skilled in the art realizes that the present disclosure is not limited to the embodiments described above. The person skilled in the art further realizes that modifications and variations are possible within the scope of the appended claims. For example, it should be realized that all or some of the functionality described herein as residing in the network node 80 may, in other embodiments, reside in the acoustic sensor 30. In yet other embodiments, all or some of the functionality described herein as residing in the network node 80 may reside in a client device that is operatively connected to any of the acoustic sensor device 30 and the network server 80, such as any of the electronic devices 70A-70C. Consequently, it should be realized that the system 1 is not limited to any particular system configuration or system topology encompassed by the appended claims.

## Claims

1. A method for detection of electrical abnormalities in association with electrical equipment (100), the method comprises
- registering (S11), by an acoustic sensor device (30) during a calibration process (S10), acoustic signals reflecting sound of the electrical equipment (100) during normal operation thereof;
- comparing (S111) energy contents of different frequencies of the acoustic signals registered during the calibration process;
- determining (S112) at least one frequency band (Δf_{A}, Δf_{B}) to be monitored during monitoring of the electrical equipment (100) following the calibration process as a frequency band having a relatively low energy content, based on the comparison;
- determining (S12) an energy content threshold value (E_{th_A}, E_{th_B}) for acoustic signals within the at least one frequency band (Δf_{A}, Δf_{B}) to be monitored, based on the acoustic signals registered within the at least one frequency band during the calibration process;
- detecting (S22), among acoustic signals registered by the acoustic sensor device (30) during monitoring (S20) of the electrical equipment (100) following the calibration process (S10), an acoustic pulse (P) within the at least one frequency band (Δf_{A}, Δf_{B}), and
- classifying (S24) the acoustic pulse (P) as an electrical abnormality associated with the electrical equipment (100) when an energy content of the acoustic pulse (P) exceeds the energy content threshold value (E_{th_A}, E_{th_B}).

2. The method of claim 1, wherein each of the at least one frequency band (Δf_{A}, Δf_{B}) has a bandwidth of at most 100 Hz, preferably at most 75 Hz, and even more preferably at most 50 Hz.

3. The method of claim 1 or 2, further comprising the steps of:
- determining (S23B) a pulse duration time (Δtₚ) of the acoustic pulse (P), and
- classifying (S24) the acoustic pulse (P) as an electrical abnormality only when the pulse duration time (Δtₚ) is below a maximum pulse duration threshold value.

4. The method of any of the preceding claims, further comprising the steps of:
- determining (S23C) a measure indicative of a rate of increase of energy content of the acoustic pulse (P), and
- classifying (S24) the acoustic pulse (P) as an electrical abnormality only when the measure of the rate of increase exceeds a set threshold value.

5. The method of any of the preceding claims, further comprising the steps of:
- determining (S23D)a measure indicative of a rate of decrease of energy content of the acoustic pulse (P), and
- classifying (S24) the acoustic pulse (P) as an electrical abnormality only when the measure of the rate of decrease exceeds a set threshold value.

6. The method of any of the preceding claims, further comprising the step of:
- generating (S31) an alarm signal and/or automatically switching off (S32) the electrical equipment (100) in response to classifying (S24) the acoustic pulse (P) as an electrical abnormality.

7. The method of any of the preceding claims, wherein the sound of the electrical equipment (100) is picked up by the acoustic sensor device (30) from a mounting rail (10) for electrical equipment onto which the acoustic sensor device is mounted, an electrical cable onto which the acoustic sensor device is mounted, or an electrical connector into which the acoustic sensor device is integrated.

8. A computer program comprising computer-readable instructions which, when executed by at least one processor (303, 803) of a system (1) for detection of electrical abnormalities in association with electrical equipment (100), causes the at least one processor to perform the steps of:
- receiving acoustic signals reflecting sound of the electrical equipment (100) during normal operation thereof, registered during a calibration process by an acoustic sensor device (30) that is operatively coupled to the at least one processor (303, 803);
- comparing energy contents of different frequencies of the acoustic signals registered during the calibration process;
- determining at least one frequency band (Δf_{A}, Δf_{B}) to be monitored during monitoring of the electrical equipment (100) following the calibration process as a frequency band having a relatively low energy content, based on the comparison;
- determining an energy content threshold value (E_{th_A}, E_{th_B}) for acoustic signals within the at least one frequency band (Δf_{A}, Δf_{B}) to be monitored, based on the acoustic signals registered within the at least one frequency band (Δf_{A}, Δf_{B}) during the calibration process;
- detecting, among the acoustic signals registered by the acoustic sensor device (30) during monitoring (SX) of the electrical equipment (100) following the calibration process, an acoustic pulse (P) within the at least one frequency band (Δf_{A}, Δf_{B}), and
- classifying the acoustic pulse (P) as an electrical abnormality associated with the electrical equipment (100) when an energy content of the acoustic pulse (P) exceeds the energy content threshold value (E_{th_A}, Eₜₕ).

9. A system (1) for detection of electrical abnormalities in association with electrical equipment (100), the system comprises an acoustic sensor device (30) for registering acoustic signals reflecting sound of the electrical equipment (100), and at least one processor (303, 803) operatively coupled to the acoustic sensor device (30) and configured to:
- receive acoustic signals registered by the acoustic sensor device (30) during a calibration process;
- compare energy contents of different frequencies of the acoustic signals registered by the acoustic sensor device (30) during the calibration process;
- determine at least one frequency band (Δf_{A}, Δf_{B}) to be monitored during monitoring of the electrical equipment (100) following the calibration process as a frequency band having a relatively low energy content, based on the comparison;
- determine an energy content threshold value (E_{th_A}, E_{th_B}) for acoustic signals within the at least one frequency band (Δf_{A}, Δf_{B}) to be monitored, based on the acoustic signals registered within the at least one frequency band during the calibration process;
- detect, among the acoustic signals registered by the acoustic sensor device (30) during monitoring of the electrical equipment (100) following the calibration process, an acoustic pulse (P) within the at least one frequency band (Δf_{A}, Δf_{B}), and
- classify the acoustic pulse (P) as an electrical abnormality associated with the electrical equipment (100) when an energy content of the acoustic pulse (P) exceeds the energy content threshold value (E_{th_A}, E_{th_B}).

10. The system (1) of claim 9, wherein each of the at least one frequency band (Δf_{A}, Δf_{B}) has a bandwidth of at most 100 Hz, preferably at most 75 Hz, and even more preferably at most 50 Hz.

11. The system (1) of claim 9 or 10, wherein the at least one processor (303, 803) is configured to:
- determine a pulse duration time (Δtₚ) of the acoustic pulse (P), and
- classify the acoustic pulse (P) as an electrical abnormality only when the pulse duration time (Δtₚ) is below a maximum pulse duration threshold value.

12. The system (1) of any of the claims 9-11, wherein the at least one processor (303, 803) is configured to:
- determine a measure indicative of a rate of increase of energy content of the acoustic pulse (P), and
- classify the acoustic pulse (P) as an electrical abnormality only when the measure of the rate of increase exceeds a set threshold value.

13. The system (1) of any of the claims 9-12, wherein the at least one processor (303, 803) is configured to:
- determine a measure indicative of a rate of decrease of energy content of the acoustic pulse (P), and
- classify the acoustic pulse (P) as an electrical abnormality only when the measure of the rate of decrease exceeds a set threshold value.

14. The system (1) of any of the claims 9-13, wherein the at least one processor (303, 803) is configured to generate an alarm signal and/or to automatically switch off the electrical equipment (100) in response to classifying the acoustic signal (P) as an electrical abnormality.

15. The system (1) of any of the claims 9-14, wherein the acoustic sensor device (30) is configured to pick up the sound of the electrical equipment (100) from a mounting rail (10) for electrical equipment onto which the acoustic sensor device (30) is mounted, an electrical cable onto which the acoustic sensor device (30) is mounted, or an electrical connector onto or into which the acoustic sensor device (30) is mounted or integrated.

## Patentansprüche

1. Verfahren zur Erkennung elektrischer Anomalien in Zusammenhang mit elektrischer Ausrüstung (100), wobei das Verfahren Folgendes umfasst:
- Registrieren (S11), durch eine akustische Sensorvorrichtung (30) während eines Kalibrierungsprozesses (S10), von akustischen Signalen, die Schall der elektrischen Ausrüstung (100) während Normalbetrieb derselben reflektieren;
- Vergleichen (S111) von Energiegehalten unterschiedlicher Frequenzen der akustischen Signale, die während des Kalibrierungsprozesses registriert werden;
- Bestimmen (S112), basierend auf dem Vergleich, von mindestens einem Frequenzband (Δf_{A}, Δf_{B}), das während Überwachen der elektrischen Ausrüstung (100) nach dem Kalibrierungsprozess zu überwachen ist, als ein Frequenzband, das einen relativ niedrigen Energiegehalt aufweist;
- Bestimmen (S12) eines Energiegehaltschwellenwerts (E_{th_A}, E_{th_B}) für akustische Signale innerhalb des mindestens einen zu überwachenden Frequenzbands (Δf_{A}, Δf_{B}) basierend auf den akustischen Signalen, die innerhalb des mindestens einen Frequenzbands während des Kalibrierungsprozesses registriert werden;
- Erkennen (S22), aus akustischen Signalen, die durch die akustische Sensorvorrichtung (30) während des Überwachens (S20) der elektrischen Ausrüstung (100) nach dem Kalibrierungsprozess (S10) registriert werden, eines akustischen Impulses (P) innerhalb des mindestens einen Frequenzbands (Δf_{A}, Δf_{B}) und
- Klassifizieren (S24) des akustischen Impulses (P) als eine elektrische Anomalie in Zusammenhang mit der elektrischen Ausrüstung (100), wenn ein Energiegehalt des akustischen Impulses (P) den Energiegehaltschwellenwert (E_{th_A}, E_{th_B}) überschreitet.

2. Verfahren nach Anspruch 1, wobei jedes des mindestens einen Frequenzbands (Δf_{A}, Δf_{B}) eine Bandbreite von höchstens 100 Hz, bevorzugt höchstens 75 Hz und noch stärker bevorzugt höchstens 50 Hz aufweist.

3. Verfahren nach Anspruch 1 oder 2, ferner umfassend die folgenden Schritte:
- Bestimmen (S23B) einer Impulsdauer (Δtₚ) des akustischen Impulses (P) und
- Klassifizieren (S24) des akustischen Impulses (P) als eine elektrische Anomalie nur dann, wenn die Impulsdauer (Δtₚ) unter einem maximalen Impulsdauerschwellenwert liegt.

4. Verfahren nach einem der vorhergehenden Ansprüche, ferner umfassend die folgenden Schritte:
- Bestimmen (S23C) eines Maßes, das eine Energiegehaltanstiegsrate des akustischen Impulses (P) angibt, und
- Klassifizieren (S24) des akustischen Impulses (P) als eine elektrische Anomalie nur dann, wenn das Maß der Anstiegsrate einen eingestellten Schwellenwert überschreitet.

5. Verfahren nach einem der vorhergehenden Ansprüche, ferner umfassend die folgenden Schritte:
- Bestimmen (S23D) eines Maßes, das eine Energiegehaltabfallrate des akustischen Impulses (P) angibt, und
- Klassifizieren (S24) des akustischen Impulses (P) als eine elektrische Anomalie nur dann, wenn das Maß der Abfallrate einen eingestellten Schwellenwert überschreitet.

6. Verfahren nach einem der vorhergehenden Ansprüche, ferner umfassend den folgenden Schritt:
- Erzeugen (S31) eines Alarmsignals und/oder automatisches Ausschalten (S32) der elektrischen Ausrüstung (100) als Reaktion auf das Klassifizieren (S24) des akustischen Impulses (P) als eine elektrische Anomalie.

7. Verfahren nach einem der vorhergehenden Ansprüche, wobei der Schall der elektrischen Ausrüstung (100) durch die akustische Sensorvorrichtung (30) von einer Montageschiene (10) für elektrische Ausrüstung, an welcher die akustische Sensorvorrichtung montiert ist, einem elektrischen Kabel, an dem die akustische Sensorvorrichtung montiert ist, oder einem elektrischen Verbinder, in dem die akustische Sensorvorrichtung integriert ist, aufgenommen wird.

8. Computerprogramm, umfassend computerlesbare Anweisungen, die bei Ausführung durch mindestens einen Prozessor (303, 803) eines Systems (1) zur Erkennung elektrischer Anomalien in Zusammenhang mit elektrischer Ausrüstung (100) den mindestens einen Prozessor veranlasst, die folgenden Schritte durchzuführen:
- Empfangen von akustischen Signalen, die Schall der elektrischen Ausrüstung (100) während Normalbetrieb derselben reflektieren und während eines Kalibrierungsprozesses durch eine akustische Sensorvorrichtung (30), die an den mindestens einen Prozessor (303, 803) wirkgekoppelt ist, registriert werden;
- Vergleichen von Energiegehalten unterschiedlicher Frequenzen der akustischen Signale, die während des Kalibrierungsprozesses registriert werden;
- Bestimmen, basierend auf dem Vergleich, von mindestens einem Frequenzband (Δf_{A}, Δf_{B}), das während Überwachen der elektrischen Ausrüstung (100) nach dem Kalibrierungsprozess zu überwachen ist, als ein Frequenzband, das einen relativ niedrigen Energiegehalt aufweist;
- Bestimmen eines Energiegehaltschwellenwerts (E_{th_A}, E_{th_B}) für akustische Signale innerhalb des mindestens einen zu überwachenden Frequenzbands (Δf_{A}, Δf_{B}) basierend auf den akustischen Signalen, die innerhalb des mindestens einen Frequenzbands (Δf_{A}, Δf_{B}) während des Kalibrierungsprozesses registriert werden;
- Erkennen, aus den akustischen Signalen, die durch die akustische Sensorvorrichtung (30) während des Überwachens (SX) der elektrischen Ausrüstung (100) nach dem Kalibrierungsprozess registriert werden, eines akustischen Impulses (P) innerhalb des mindestens einen Frequenzbands (Δf_{A}, Δf_{B}) und
- Klassifizieren des akustischen Impulses (P) als eine elektrische Anomalie in Zusammenhang mit der elektrischen Ausrüstung (100), wenn ein Energiegehalt des akustischen Impulses (P) den Energiegehaltschwellenwert (E_{th_A}, E_{th_B}) überschreitet.

9. System (1) zur Erkennung elektrischer Anomalien in Zusammenhang mit elektrischer Ausrüstung (100), wobei das System eine akustische Sensorvorrichtung (30) zum Registrieren von akustischen Signalen, die Schall der elektrischen Ausrüstung (100) reflektieren, und mindestens einen Prozessor (303, 803) umfasst, der an die akustische Sensorvorrichtung (30) wirkgekoppelt und zu Folgendem konfiguriert ist:
- Empfangen von akustischen Signalen, die durch die akustische Sensorvorrichtung (30) während eines Kalibrierungsprozesses registriert werden;
- Vergleichen von Energiegehalten unterschiedlicher Frequenzen der akustischen Signale, die durch die akustische Sensorvorrichtung (30) während des Kalibrierungsprozesses registriert werden;
- Bestimmen, basierend auf dem Vergleich, von mindestens einem Frequenzband (Δf_{A}, Δf_{B}), das während Überwachen der elektrischen Ausrüstung (100) nach dem Kalibrierungsprozess zu überwachen ist, als ein Frequenzband, das einen relativ niedrigen Energiegehalt aufweist;
- Bestimmen eines Energiegehaltschwellenwerts (E_{th_A}, E_{th_B}) für akustische Signale innerhalb des mindestens einen zu überwachenden Frequenzbands (Δf_{A}, Δf_{B}) basierend auf den akustischen Signalen, die innerhalb des mindestens einen Frequenzbands während des Kalibrierungsprozesses registriert werden;
- Erkennen, aus den akustischen Signalen, die durch die akustische Sensorvorrichtung (30) während des Überwachens der elektrischen Ausrüstung (100) nach dem Kalibrierungsprozess registriert werden, eines akustischen Impulses (P) innerhalb des mindestens einen Frequenzbands (Δf_{A}, Δf_{B}) und
- Klassifizieren des akustischen Impulses (P) als eine elektrische Anomalie in Zusammenhang mit der elektrischen Ausrüstung (100), wenn ein Energiegehalt des akustischen Impulses (P) den Energiegehaltschwellenwert (E_{th_A}, E_{th_B}) überschreitet.

10. System (1) nach Anspruch 9, wobei jedes des mindestens einen Frequenzbands (Δf_{A}, Δf_{B}) eine Bandbreite von höchstens 100 Hz, bevorzugt höchstens 75 Hz und noch stärker bevorzugt höchstens 50 Hz aufweist.

11. System (1) nach Anspruch 9 oder 10, wobei der mindestens eine Prozessor (303, 803) zu Folgendem konfiguriert ist:
- Bestimmen einer Impulsdauer (Δtₚ) des akustischen Impulses (P) und
- Klassifizieren des akustischen Impulses (P) als eine elektrische Anomalie nur dann, wenn die Impulsdauer (Δtₚ) unter einem maximalen Impulsdauerschwellenwert liegt.

12. System (1) nach einem der Ansprüche 9-11, wobei der mindestens eine Prozessor (303, 803) zu Folgendem konfiguriert ist:
- Bestimmen eines Maßes, das eine Energiegehaltanstiegsrate des akustischen Impulses (P) angibt, und
- Klassifizieren des akustischen Impulses (P) als eine elektrische Anomalie nur dann, wenn das Maß der Anstiegsrate einen eingestellten Schwellenwert überschreitet.

13. System (1) nach einem der Ansprüche 9-12, wobei der mindestens eine Prozessor (303, 803) zu Folgendem konfiguriert ist:
- Bestimmen eines Maßes, das eine Energiegehaltabfallrate des akustischen Impulses (P) angibt, und
- Klassifizieren des akustischen Impulses (P) als eine elektrische Anomalie nur dann, wenn das Maß der Abfallrate einen eingestellten Schwellenwert überschreitet.

14. System (1) nach einem der Ansprüche 9-13, wobei der mindestens eine Prozessor (303, 803) dazu konfiguriert ist, als Reaktion auf das Klassifizieren des akustischen Signals (P) als eine elektrische Anomalie ein Alarmsignal zu erzeugen und/oder die elektrische Ausrüstung (100) automatisch auszuschalten.

15. System (1) nach einem der Ansprüche 9-14, wobei die akustische Sensorvorrichtung (30) dazu konfiguriert ist, Schall der elektrischen Ausrüstung (100) von einer Montageschiene (10) für elektrische Ausrüstung, an welcher die akustische Sensorvorrichtung (30) montiert ist, einem elektrischen Kabel, an dem die akustische Sensorvorrichtung (30) montiert ist, oder einem elektrischen Verbinder, in dem die akustische Sensorvorrichtung (30) integriert ist, aufzunehmen.

## Revendications

1. Procédé pour la détection d'anomalies électriques en association avec un équipement électrique (100), le procédé comprenant :
- l'enregistrement (S11), par un dispositif de détection acoustique (30) pendant un processus d'étalonnage (S10), de signaux acoustiques reflétant le son de l'équipement électrique (100) pendant un fonctionnement normal de celui-ci ;
- la comparaison (S111) de contenus énergétiques de différentes fréquences des signaux acoustiques enregistrés pendant le processus d'étalonnage ;
- la détermination (S112) d'au moins une bande de fréquences (Δf_{A}, Δf_{B}) à surveiller pendant la surveillance de l'équipement électrique (100) à la suite du processus d'étalonnage en tant que bande de fréquences ayant un contenu énergétique relativement bas, sur la base de la comparaison ;
- la détermination (S12) d'une valeur seuil de contenu énergétique (E_{th_A}, E_{th_B}) pour des signaux acoustiques au sein de l'au moins une bande de fréquences (Δf_{A}, Δf_{B}) à surveiller, sur la base des signaux acoustiques enregistrés au sein de l'au moins une bande de fréquences pendant le processus d'étalonnage ;
- la détection (S22), parmi des signaux acoustiques enregistrés par le dispositif de détection acoustique (30) pendant la surveillance (S20) de l'équipement électrique (100) à la suite du processus d'étalonnage (S10), d'une impulsion acoustique (P) au sein de l'au moins une bande de fréquences (Δf_{A}, Δf_{B}), et
- la classification (S24) de l'impulsion acoustique (P) en tant qu'anomalie électrique associée à l'équipement électrique (100) lorsqu'un contenu énergétique de l'impulsion acoustique (P) dépasse la valeur seuil de contenu énergétique (E_{th_A}, E_{th_B}).

2. Procédé selon la revendication 1, dans lequel chacune de l'au moins une bande de fréquences (Δf_{A}, Δf_{B}) présente une largeur de bande d'au plus 100 Hz, de préférence d'au plus 75 Hz, et encore plus préférablement d'au plus 50 Hz.

3. Procédé selon la revendication 1 ou 2, comprenant en outre les étapes consistant à :
- déterminer (S23B) un temps de durée d'impulsion (Δtₚ) de l'impulsion acoustique (P), et
- classifier (S24) l'impulsion acoustique (P) en tant qu'anomalie électrique uniquement lorsque le temps de durée d'impulsion (Δtₚ) est inférieur à une valeur seuil de durée d'impulsion maximale.

4. Procédé selon l'une quelconque des revendications précédentes, comprenant en outre les étapes consistant à :
- déterminer (S23C) une mesure indicative d'un taux d'augmentation de contenu énergétique de l'impulsion acoustique (P), et
- classifier (S24) l'impulsion acoustique (P) en tant qu'anomalie électrique uniquement lorsque la mesure du taux d'augmentation dépasse une valeur seuil définie.

5. Procédé selon l'une quelconque des revendications précédentes, comprenant en outre les étapes consistant à :
- déterminer (S23D) une mesure indicative d'un taux de diminution de contenu énergétique de l'impulsion acoustique (P), et
- classifier (S24) l'impulsion acoustique (P) en tant qu'anomalie électrique uniquement lorsque la mesure du taux de diminution dépasse une valeur seuil définie.

6. Procédé selon l'une quelconque des revendications précédentes, comprenant en outre l'étape consistant à :
- générer (S31) un signal d'alarme et/ou mettre hors tension automatiquement (S32) l'équipement électrique (100) en réponse à la classification (S24) de l'impulsion acoustique (P) en tant qu'anomalie électrique.

7. Procédé selon l'une quelconque des revendications précédentes, dans lequel le son de l'équipement électrique (100) est capté par le dispositif de détection acoustique (30) à partir d'un rail de montage (10) pour équipement électrique sur lequel le dispositif de détection acoustique est monté, d'un câble électrique sur lequel le dispositif de détection acoustique est monté, ou d'un connecteur électrique dans lequel le dispositif de détection acoustique est intégré.

8. Programme informatique comprenant des instructions lisibles par ordinateur qui, lorsqu'elles sont exécutées par au moins un processeur (303, 803) d'un système (1) pour la détection d'anomalies électriques en association avec un équipement électrique (100), amènent l'au moins un processeur à réaliser les étapes consistant à :
- recevoir des signaux acoustiques reflétant le son de l'équipement électrique (100) pendant un fonctionnement normal de celui-ci, enregistrés pendant un processus d'étalonnage par un dispositif de détection acoustique (30) qui est couplé de manière fonctionnelle à l'au moins un processeur (303, 803) ;
- comparer des contenus énergétiques de différentes fréquences des signaux acoustiques enregistrés pendant le processus d'étalonnage ;
- déterminer au moins une bande de fréquences (Δf_{A}, Δf_{B}) à surveiller pendant la surveillance de l'équipement électrique (100) à la suite du processus d'étalonnage en tant que bande de fréquences ayant un contenu énergétique relativement bas, sur la base de la comparaison ;
- déterminer une valeur seuil de contenu énergétique (E_{th_A}, E_{th_B}) pour des signaux acoustiques au sein de l'au moins une bande de fréquences (Δf_{A}, Δf_{B}) à surveiller, sur la base des signaux acoustiques enregistrés au sein de l'au moins une bande de fréquences (Δf_{A}, Δf_{B}) pendant le processus d'étalonnage ;
- détecter, parmi les signaux acoustiques enregistrés par le dispositif de détection acoustique (30) pendant la surveillance (SX) de l'équipement électrique (100) à la suite du processus d'étalonnage, une impulsion acoustique (P) au sein de l'au moins une bande de fréquences (Δf_{A}, Δf_{B}), et
- classifier l'impulsion acoustique (P) en tant qu'anomalie électrique associée à l'équipement électrique (100) lorsqu'un contenu énergétique de l'impulsion acoustique (P) dépasse la valeur seuil de contenu énergétique (E_{th_A}, E_{th_B}).

9. Système (1) pour la détection d'anomalies électriques en association avec un équipement électrique (100), le système comprenant un dispositif de détection acoustique (30) pour enregistrer des signaux acoustiques reflétant le son de l'équipement électrique (100), et au moins un processeur (303, 803) couplé de manière fonctionnelle au dispositif de détection acoustique (30) et configuré pour :
- recevoir des signaux acoustiques enregistrés par le dispositif de détection acoustique (30) pendant un processus d'étalonnage ;
- comparer des contenus énergétiques de différentes fréquences des signaux acoustiques enregistrés par le dispositif de détection acoustique (30) pendant le processus d'étalonnage ;
- déterminer au moins une bande de fréquences (Δf_{A}, Δf_{B}) à surveiller pendant la surveillance de l'équipement électrique (100) à la suite du processus d'étalonnage en tant que bande de fréquences ayant un contenu énergétique relativement bas, sur la base de la comparaison ;
- déterminer une valeur seuil de contenu énergétique (E_{th_A}, E_{th_B}) pour des signaux acoustiques au sein de l'au moins une bande de fréquences (Δf_{A}, Δf_{B}) à surveiller, sur la base des signaux acoustiques enregistrés au sein de l'au moins une bande de fréquences pendant le processus d'étalonnage ;
- détecter, parmi les signaux acoustiques enregistrés par le dispositif de détection acoustique (30) pendant la surveillance de l'équipement électrique (100) à la suite du processus d'étalonnage, une impulsion acoustique (P) au sein de l'au moins une bande de fréquences (Δf_{A}, Δf_{B}), et
- classifier l'impulsion acoustique (P) en tant qu'anomalie électrique associée à l'équipement électrique (100) lorsqu'un contenu énergétique de l'impulsion acoustique (P) dépasse la valeur seuil de contenu énergétique (E_{th_A}, E_{th_B}).

10. Système (1) selon la revendication 9, dans lequel chacune de l'au moins une bande de fréquences (Δf_{A}, Δf_{B}) présente une largeur de bande d'au plus 100 Hz, de préférence d'au plus 75 Hz, et encore plus préférablement d'au plus 50 Hz.

11. Système (1) selon la revendication 9 ou 10, dans lequel l'au moins un processeur (303, 803) est configuré pour :
- déterminer un temps de durée d'impulsion (Δtₚ) de l'impulsion acoustique (P), et
- classifier l'impulsion acoustique (P) en tant qu'anomalie électrique uniquement lorsque le temps de durée d'impulsion (Δtₚ) est inférieur à une valeur seuil de durée d'impulsion maximale.

12. Système (1) selon l'une quelconque des revendications 9 à 11, dans lequel l'au moins un processeur (303, 803) est configuré pour :
- déterminer une mesure indicative d'un taux d'augmentation de contenu énergétique de l'impulsion acoustique (P), et
- classifier l'impulsion acoustique (P) en tant qu'anomalie électrique uniquement lorsque la mesure du taux d'augmentation dépasse une valeur seuil définie.

13. Système (1) selon l'une quelconque des revendications 9 à 12, dans lequel l'au moins un processeur (303, 803) est configuré pour :
- déterminer une mesure indicative d'un taux de diminution de contenu énergétique de l'impulsion acoustique (P), et
- classifier l'impulsion acoustique (P) en tant qu'anomalie électrique uniquement lorsque la mesure du taux de diminution dépasse une valeur seuil définie.

14. Système (1) selon l'une quelconque des revendications 9 à 13, dans lequel l'au moins un processeur (303, 803) est configuré pour générer un signal d'alarme et/ou pour mettre hors tension automatiquement l'équipement électrique (100) en réponse à la classification de l'impulsion acoustique (P) en tant qu'anomalie électrique.

15. Système (1) selon l'une quelconque des revendications 9 à 14, dans lequel le dispositif de détection acoustique (30) est configuré pour capter le son de l'équipement électrique (100) à partir d'un rail de montage (10) pour équipement électrique sur lequel le dispositif de détection acoustique (30) est monté, d'un câble électrique sur lequel le dispositif de détection acoustique (30) est monté, ou d'un connecteur électrique sur ou dans lequel le dispositif de détection acoustique (30) est monté ou intégré.
